# EUROPEAN PATENT APPLICATION

(11) **EP 4 693 295 A1**
(43) Date of publication of application: **11.02.2026**
(21) Application number: 24791737.0
(22) Date of filing: 26.02.2024
(51) Int. Cl.: G11C 11/22

(54) **MEMORY AND CONTROL METHOD THEREFOR, MEMORY DEVICE, AND ELECTRONIC DEVICE**

(30) Priority: 18.04.2023 CN 202310457357
(71) Applicant: Huawei Technologies Co., Ltd., Shenzhen, Guangdong 518129 (CN)
(72) Inventor: WANG, Tong, Shenzhen, Guangdong 518129 (CN); LI, Danhui, Shenzhen, Guangdong 518129 (CN); JI, Bingwu, Shenzhen, Guangdong 518129 (CN); WANG, Yunpeng, Shenzhen, Guangdong 518129 (CN)
(74) Representative: Pfenning, Meinig & Partner mbB
(86) International application number: PCT/CN2024/078592
(87) International publication number: WO 2024/217149

(57) **Abstract**

Embodiments of this application provide a memory, a control method for the memory, and an electronic device, and relate to the field of memory technologies, to resolve a problem that a sense amplifier in the memory cannot meet requirements of both high-sensitivity sensing and high-voltage write-back. The memory includes a sense amplifier, a first bit line, and a second bit line, and the sense amplifier includes a sense amplification circuit, a first switch circuit, and a second switch circuit. A first input terminal of the sense amplification circuit is connected to the first bit line, a second input terminal is connected to the second bit line, a first power supply terminal of the sense amplification circuit is connected to the first switch circuit, and a second power supply terminal is connected to the second switch circuit. The first switch circuit is configured to switch the first power supply terminal between conducting electricity with a first power supply and conducting electricity with a second power supply, where a voltage of the second power supply is greater than a voltage of the first power supply. The second switch circuit is configured to switch the second power supply terminal between conducting electricity with a third power supply and conducting electricity with a fourth power supply, where a voltage of the fourth power supply is greater than a voltage of the third power supply.

## Description

This application claims priority to Chinese Patent Application No. 202310457357.1, filed with the China National Intellectual Property Administration on April 18, 2023 and entitled "MEMORY, CONTROL METHOD FOR MEMORY, STORAGE DEVICE, AND ELECTRONIC DEVICE", which is incorporated herein by reference in its entirety.

### TECHNICAL FIELD

This application relates to the field of memory technologies, and in particular, to a memory, a control method for the memory, a storage device, and an electronic device.

### BACKGROUND

For memories such as a dynamic random access memory and a ferroelectric random access memory, a sense amplifier needs to be used to amplify a read voltage on a bit line in a read operation, and to provide a power signal for the bit line in a write-back stage to write data back into a memory cell. The sense amplifier usually includes a core device (core device) that is sensitive to a subtle voltage difference, and the core device has a low withstand voltage. However, voltages required by some memories (for example, the ferroelectric random access memory) to write back data are high, and exceed a withstand voltage range of the core device. If the sense amplifier uses an input/output device (I/O device) with a high withstand voltage, and the I/O device is insensitive to a subtle voltage difference, data may not be accurately read. Consequently, the current sense amplifier cannot meet requirements of both high-sensitivity sensing and high-voltage write-back.

### SUMMARY

Embodiments of this application provide a memory, a control method for the memory, a storage device, and an electronic device, to resolve a problem that a sense amplifier cannot meet requirements of both high-sensitivity sensing and high-voltage write-back.

According to a first aspect, an embodiment of this application provides a memory. The memory includes a memory cell array and a sense amplifier. The memory cell array includes a first bit line and a second bit line, the memory may include a plurality of memory cell arrays, the first bit line and the second bit line may be two bit lines in a same memory cell array, or may be two bit lines in different memory cell arrays. The sense amplifier includes a sense amplification circuit, a first switch circuit, and a second switch circuit, and the sense amplification circuit includes a first input terminal, a second input terminal, a first power supply terminal, and a second power supply terminal. The first input terminal is connected to the first bit line, and the second input terminal is connected to the second bit line. When data in a memory cell on the first bit line is read, the first bit line is referred to as a bit line true, and the second bit line is referred to as a bit line bar. Alternatively, when data in a memory cell on the second bit line is read, the second bit line is referred to as a bit line true, and the first bit line is referred to as a bit line bar. The first power supply terminal and the second power supply terminal of the sense amplifier are configured to connect to power signals. The first power supply terminal is connected to the first switch circuit, and is configured to connect to a low-level power signal, and the first switch circuit is configured to switch the first power supply terminal between conducting electricity with a first power supply and conducting electricity with a second power supply, where a voltage of the second power supply is greater than a voltage of the first power supply. The second power supply terminal is connected to the second switch circuit, and is configured to connect to a high-level power signal, and the second switch circuit is configured to switch the second power supply terminal between conducting electricity with a third power supply and conducting electricity with a fourth power supply, where a voltage of the fourth power supply is greater than a voltage of the third power supply.

In the memory provided in embodiments of this application, the first power supply terminal and the second power supply terminal of the sense amplification circuit of the memory may be connected to different power signals by using a switching switch. For example, in a sensing stage of an access operation of the memory, the first power supply terminal may be connected to the first power supply by using the first switch circuit, and the second power supply terminal is connected to the third power supply by using the second switch circuit. In a stage like a write-back stage, the second power supply terminal may be connected to the fourth power supply with a higher voltage by using the second switch circuit, to meet a voltage required for write-back. To sense a subtle voltage difference, the sense amplifier usually uses a thin gate device sensitive to a subtle voltage change, and the thin gate device has a low withstand voltage. Therefore, when the second power supply terminal is connected to the fourth power supply with a higher voltage by using the second switch circuit, the first power supply terminal may also be connected, by using the first switch circuit, to the second power supply whose voltage is higher than that of the first power supply, to avoid an excessively large voltage difference between the second power supply terminal and the first power supply terminal that exceeds a withstand voltage range of the internal device of the sense amplifier. In addition, the first power supply terminal and the second power supply terminal are connected to different power supplies, so that high-voltage write-back is implemented, and the voltage difference between the second power supply terminal and the first power supply terminal does not exceed the withstand voltage range of the internal device of the sense amplifier. Therefore, the sense amplifier can meet requirements of both sensitivity sensing and high-voltage write-back.

In a possible implementation, the sense amplifier may work in a first working state and a second working state. In the first working state, the first switch circuit is configured for the first power supply terminal to conduct electricity with the first power supply, and the second switch circuit is configured for the second power supply terminal to conduct electricity with the third power supply. In the second working state, the first switch circuit is configured for the first power supply terminal to conduct electricity with the second power supply, and the second switch circuit is configured for the second power supply terminal to conduct electricity with the third power supply. The two different working states may correspond to different working environments of the sense amplifier. In a stage like a sensing stage of an access process of the memory, the first switch circuit and the second switch circuit select to connect to the first power supply and the third power supply. In a stage like a write-back stage, the first switch circuit and the second switch circuit select to connect to the second power supply and the fourth power supply.

In a possible implementation, when the sense amplifier is in a write stage, and a ferroelectric memory is used as an example, writing data into the memory cell requires a high write voltage, where the write stage is a stage in which data is written into the memory cell, for example, a write stage of a write operation or a write-back stage of a read operation. Therefore, the first switch circuit is configured for the first power supply terminal to conduct electricity with the second power supply, and the second switch circuit is configured for the second power supply terminal to conduct electricity with the fourth power supply, to provide a high voltage for the sense amplifier, so as to meet a voltage requirement for writing data. When the sense amplifier is in a non-write stage, for example, a trigger stage of a read/write operation, the first switch circuit is configured for the first power supply terminal to conduct electricity with the first power supply, and the second switch circuit is configured for the second power supply terminal to conduct electricity with the third power supply. In the non-write stage, writing data into the memory cell does not require a high power supply voltage. Therefore, a low power supply voltage may be selected, to meet a requirement of high-sensitivity detection.

In a possible implementation, the first switch circuit includes a first switch, a second switch, a first common terminal, a first selection terminal, and a second selection terminal, the first common terminal is connected to the first power supply terminal, the first selection terminal is connected to the first power supply, the second selection terminal is connected to the second power supply, the first switch is connected between the first selection terminal and the first common terminal, and the second switch is connected between the second selection terminal and the first common terminal. The second switch circuit includes a third switch, a fourth switch, a second common terminal, a third selection terminal, and a fourth selection terminal, the second common terminal is connected to the second power supply terminal, the third selection terminal is connected to the third power supply, the fourth selection terminal is connected to the fourth power supply, the third switch is connected between the third selection terminal and the second common terminal, and the fourth switch is connected between the fourth selection terminal and the second common terminal.

In a possible implementation, the sense amplification circuit further includes a first transistor, a second transistor, a third transistor, and a fourth transistor. A first terminal of the first transistor is connected to the first input terminal, a first terminal of the second transistor is connected to the second input terminal, a second terminal of the first transistor and a second terminal of the second transistor are connected to the first power supply terminal, a gate of the first transistor is connected to the second input terminal, and a gate of the second transistor is connected to the first input terminal. A first terminal of the third transistor is connected to the first input terminal, a first terminal of the fourth transistor is connected to the second input terminal, a second terminal of the third transistor and a second terminal of the fourth transistor are connected to the second power supply terminal, a gate of the third transistor is connected to the second input terminal, and a gate of the fourth transistor is connected to the first input terminal.

In a possible implementation, the first transistor and the second transistor are N-type metal-oxide semiconductor field effect transistors, the third transistor and the fourth transistor are P-type metal-oxide semiconductor field effect transistors, and the first transistor, the second transistor, the third transistor, and the fourth transistor are thin gate devices. The thin gate device is sensitive to a subtle voltage change, and can sensitively sense a subtle voltage difference.

In a possible implementation, the sense amplifier further includes a first charging circuit and a second charging circuit. The first charging circuit is connected to the first bit line, the second charging circuit is connected to the second bit line, and the first charging circuit and the second charging circuit may charge the first bit line and the second bit line to a specified voltage.

According to a second aspect, an embodiment of this application further provides a control method for a memory. The memory includes a memory cell array and a sense amplifier, the memory cell array includes a first bit line and a second bit line, the sense amplifier includes a sense amplification circuit, a first switch circuit, and a second switch circuit, and the sense amplification circuit includes a first input terminal, a second input terminal, a first power supply terminal, and a second power supply terminal. The first input terminal is connected to the first bit line, the second input terminal is connected to the second bit line, the first power supply terminal is connected to the first switch circuit, and the second power supply terminal is connected to the second switch circuit. The control method includes: The first switch circuit switches the first power supply terminal between conducting electricity with a first power supply and conducting electricity with a second power supply, where a voltage of the second power supply is greater than a voltage of the first power supply. The second switch circuit switches the second power supply terminal between conducting electricity with a third power supply and conducting electricity with a fourth power supply, where a voltage of the fourth power supply is greater than a voltage of the third power supply.

In a possible implementation, the method further includes: The first switch circuit switches the first power supply terminal to conduct electricity with the first power supply, and the second switch circuit switches the second power supply terminal to conduct electricity with the third power supply; or the first switch circuit switches the first power supply terminal to conduct electricity with the second power supply, and the second switch circuit switches the second power supply terminal to conduct electricity with the fourth power supply.

According to a third aspect, an embodiment of this application further provides a storage device, including a controller and the memory provided in any implementation of the first aspect. The memory is electrically connected to the controller.

According to a fourth aspect, an embodiment of this application further provides an electronic device, including a circuit board and a storage device electrically connected to the circuit board. The storage device is the storage device provided in the third aspect.

### BRIEF DESCRIPTION OF DRAWINGS

FIG. 1 is a diagram of an electronic device according to an embodiment of this application;
FIG. 2 is a diagram of an electric hysteresis loop of a ferroelectric material according to an embodiment of this application;
FIG. 3 is a diagram of a ferroelectric memory according to an embodiment of this application;
FIG. 4 is a diagram of a ferroelectric memory according to an embodiment of this application;
FIG. 5 is a diagram of a structure of a ferroelectric memory according to an embodiment of this application;
FIG. 6 is a diagram of an application scenario of a sense amplifier according to an embodiment of this application;
FIG. 7 is a diagram of a structure of a sense amplifier according to an embodiment of this application;
FIG. 8 is a timing diagram of a read operation of a ferroelectric memory according to an embodiment of this application;
FIG. 9 is a diagram of precharging a bit line in a read operation of a ferroelectric memory according to an embodiment of this application;
FIG. 10 is a diagram of a destroying stage in a read operation of a ferroelectric memory according to an embodiment of this application;
FIG. 11 is a diagram of a sensing stage in a read operation of a ferroelectric memory according to an embodiment of this application;
FIG. 12 is a diagram of another destroying stage in a read operation of a ferroelectric memory according to an embodiment of this application;
FIG. 13 is a diagram of another sensing stage in a read operation of a ferroelectric memory according to an embodiment of this application;
FIG. 14 is a diagram of a write-back stage in a read operation of a ferroelectric memory according to an embodiment of this application;
FIG. 15 is a diagram of a ferroelectric memory according to an embodiment of this application;
FIG. 16 is a diagram of another ferroelectric memory according to an embodiment of this application;
FIG. 17 is a timing diagram of a read operation of another ferroelectric memory according to an embodiment of this application;
FIG. 18 is a diagram of a sense amplifier according to an embodiment of this application;
FIG. 19 is a diagram of another sense amplifier according to an embodiment of this application; and
FIG. 20 is a schematic flowchart of a control method for a ferroelectric memory according to an embodiment of this application.

### DESCRIPTION OF EMBODIMENTS

The following describes technical solutions in embodiments of this application with reference to accompanying drawings in embodiments of this application. It is clear that the described embodiments are merely a part rather than all of embodiments of this application.

The terms such as "first" and "second", below are merely for convenience of description, and are not to be construed as indicating or implying relative importance or implicitly indicating a quantity of indicated technical features. Therefore, a feature limited by "first", "second", or the like may explicitly or implicitly include one or more features. In the descriptions of this application, unless otherwise stated, "a plurality of" means two or more than two. For example, a plurality of processing units means two or more processing units.

In addition, in embodiments of this application, "up", "down", "left", and "right" are not limited to definitions relative to directions in which components are schematically placed in the accompanying drawings. It should be understood that these directional terms may be relative concepts used for relative description and clarification, and may change correspondingly according to a change of a direction in which a component in the accompanying drawings is placed. In the accompanying drawings, for clarity, thicknesses of layers and areas are exaggerated, and a size proportion relationship between parts in the figures does not reflect an actual size proportion relationship.

In embodiments of this application, unless otherwise explicitly specified and limited, the term "connection" should be understood in a broad sense. For example, the "connection" may be a fixed connection, a detachable connection, or an integrated connection. Alternatively, the "connection" may be a direct connection or an indirect connection through an intermediate medium. Further, the term "electrical connection" may be a direct electrical connection or an indirect electrical connection through an intermediary.

In embodiments of this application, the term "module" is usually a functional structure divided based on logic, and the "module" may be implemented by pure hardware, or may be implemented by a combination of software and hardware. In embodiments of this application, the term "and/or" describes an association relationship between associated objects and indicates that three relationships may exist. For example, A and/or B may indicate the following three cases: Only A exists, only B exists, and both A and B exist.

In embodiments of this application, the term such as "example" or "for example" is used to represent giving an example, an illustration, or a description. Any embodiment or design scheme described as "example" or "for example" in embodiments of this application should not be explained as being more preferred or having more advantages than another embodiment or design scheme. Exactly, use of the term such as "example" or "for example" is intended to present a relative concept in a specific manner.

In embodiments of this application, a transistor may be a metal-oxide semiconductor field effect transistor (metal-oxide-semiconductor field effect transistor, MOSFET), and the transistor is classified into two types: an N (negative, negative)-type transistor (referred to as an Nmos transistor for short) and a P (positive, positive)-type transistor (referred to as a Pmos transistor for short). The transistor includes a source (source), a drain (drain), and a gate (gate). Conduction or cut-off of the transistor may be controlled by controlling a voltage input to the gate of the transistor. When the transistor is conducted, the source and the drain are conducted, and a conduction current is generated. In addition, the conduction current generated between the source and the drain varies with the voltage of the gate of the transistor. When the transistor is cut off or turned off, the source and the drain are not conducted, and no current is generated. In embodiments of this application, the source of the transistor is referred to as a first terminal, and the drain is referred to as a second terminal; or the drain is referred to as a first terminal, and the source is referred to as a second terminal. In addition, when a level of the gate is a high level, the Nmos transistor is conducted, the first terminal and the second terminal are connected, and a conduction current is generated between the first terminal and the second terminal. When the level of the gate is a low level, the Nmos transistor is cut off, the first terminal and the second terminal are not connected, and no current is generated. When the level of the gate is a low level, the Pmos transistor is conducted, the first terminal and the second terminal are connected, and a conduction current is generated. When the level of the gate is a high level, the Pmos transistor is cut off, the first terminal and the second terminal are not connected, and no current is generated.

A memory provided in embodiments of this application may be used in an electronic device. The electronic device may include electronic products such as a mobile phone (mobile phone), a tablet computer (pad), a television, an intelligent wearable product (for example, a smartwatch or a smart band), a virtual reality (virtual reality, VR) terminal device, and an augmented reality (augmented reality, AR) terminal device. A specific form of the electronic device is not specially limited in embodiments of this application.

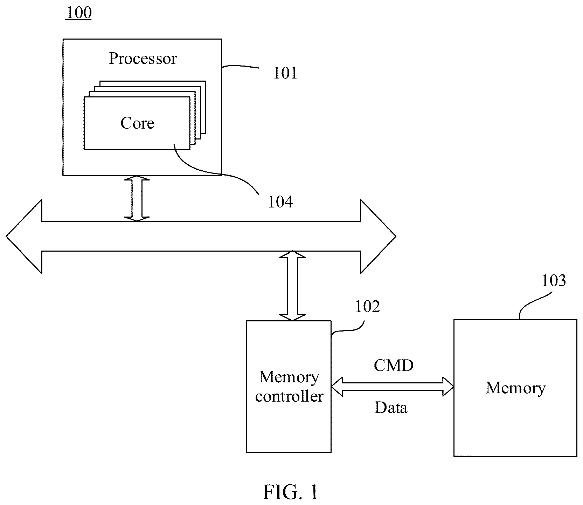

FIG. 1 is a diagram of an architecture of an electronic device according to an embodiment of this application. As shown in FIG. 1, an electronic device 100 may at least include a processor (processor) 101, a memory controller (memory controller) 102, and a memory 103. Usually, the memory controller 102 may be integrated into the processor 101. The memory 103 may be a main memory (or referred to as an internal memory). It should be noted that in the electronic device provided in this embodiment of this application, in addition to the components shown in FIG. 1, the electronic device 100 may further include other components such as a communication interface and a disk that is used as a secondary storage. This is not limited herein.

The processor 101 is an operation core and a control unit (control unit) of the electronic device 100. The processor 101 may include a plurality of cores (core) 104. An operating system and another software program are installed in the processor 101, so that the processor 101 can access the memory 103, a cache, the secondary storage, and the like. In this embodiment of this application, the core 104 in the processor 101 may be a central processing unit (central processing unit, CPU), an artificial intelligence (artificial intelligence, AI) processor, a digital signal processor (digital signal processor), a neural network processing unit, another application-specific integrated circuit (application-specific integrated circuit, ASIC), or the like.

The memory controller 102 is a bus circuit controller that controls the memory 103 inside the electronic device 100 and is configured to manage and plan data transmission from the memory 103 to the core 104. The memory controller 102 may be used for data exchange between the memory 103 and the core 104. The memory controller 102 may be an independent chip, and is connected to the core 104 through a system bus. The memory controller 102 may alternatively be integrated into the processor 101. A specific location of the memory controller 102 is not limited in this embodiment of this application. During actual application, the memory controller 102 may control necessary logic to write data into the memory 103 or read data from the memory 103.

The memory 103 is a main memory of the electronic device 100. The memory 103 is connected to the memory controller 102 through a bus. The memory 103 is usually configured to store various running software in the operating system, input and output data, information exchanged with an external memory, and the like. The memory 103 is usually a random access memory (random-access memory, RAM), for example, a dynamic random access memory (dynamic random access memory, DRAM) or a ferroelectric random access memory (ferroelectric random-access memory, FRAM).

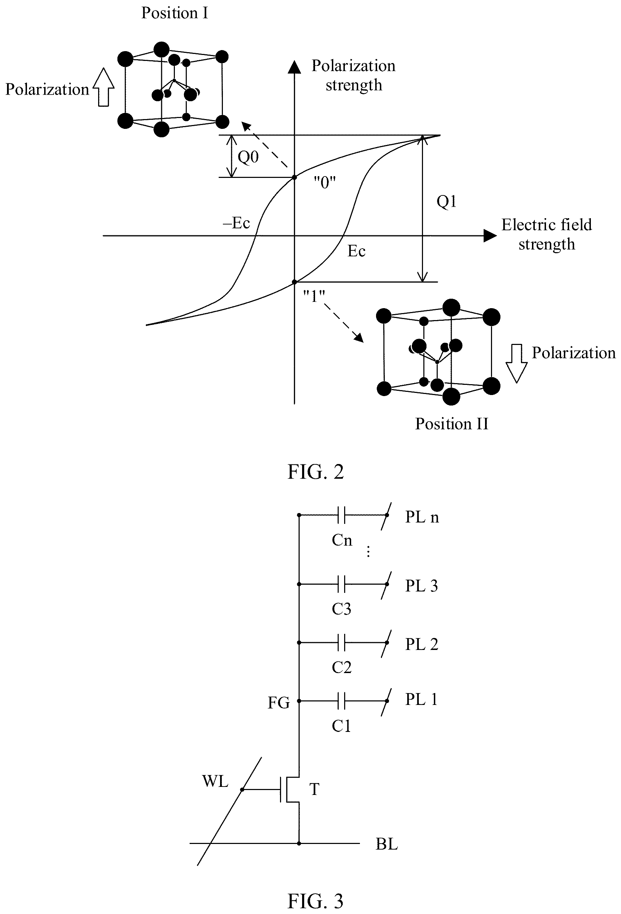

The ferroelectric random access memory is referred to as a ferroelectric memory for short. The ferroelectric memory stores data by using a feature in which a ferroelectric material has spontaneous polarization and a polarization state may be reversed by an action of an external electric field. FIG. 2 is a diagram of a ferroelectric hysteresis loop of a ferroelectric material. When an electric field is applied to a ferroelectric crystal, a central atom stays at a low-energy state position I along the electric field. On the contrary, when the electric field is switched and applied to the same ferroelectric crystal, the central atom moves in the crystal along a direction of the electric field and stays at another low-energy state position II. A large quantity of central atoms move and are coupled in a cell of the crystal to form a ferroelectric domain, and the ferroelectric domain forms a polarization charge (also referred to as a reverse charge) under an action of the electric field. To ensure that the applied electric field can reverse the polarization state of the ferroelectric material, strength of the electric field needs to be greater than coercive field strength Ec of the ferroelectric material. The coercive field strength Ec is reverse electric field strength required to reduce remanent polarization of the ferroelectric material to zero. For example, from the position I in FIG. 2 to the position II in FIG. 2, an electric field whose strength is greater than -Ec needs to be applied to the ferroelectric material, and from the position II in FIG. 2 to the position I in FIG. 2, an electric field whose strength is greater than +Ec needs to be applied to the ferroelectric material.

A reverse charge (as shown by Q1 in FIG. 2) formed by the ferroelectric domain when the electric field is reversed is high, and a reverse charge (as shown by Q0 in FIG. 2) formed by the ferroelectric domain when the electric field is not reversed is low. This binary stable state of the ferroelectric material enables the ferroelectric material to be used as a memory. When directions of remanent polarization strength are different, electric fields in a same direction are applied, and different reverse charges are generated, so that data at two binary states: 0 and 1 may be stored. When an electric field is applied to the ferroelectric crystal, a central atom moves in the crystal along a direction of the electric field. When the atom moves, the atom passes through an energy barrier, causing charge breakdown. After the electric field is removed, a position of the central atom remains unchanged, and the polarization state may also remain unchanged. Therefore, the ferroelectric material has a non-volatile feature when the ferroelectric material is used as a memory.

For example, as shown in FIG. 2, it is assumed that one polarization state (a state represented by the position I in FIG. 2) is a "0" state, and the other polarization state (a state represented by the position II in FIG. 2) is a "1" state. A ferroelectric material capacitor (referred to as a ferroelectric capacitor for short below) is used as an example. The ferroelectric capacitor is a capacitor made of a ferroelectric material as a medium, so that the ferroelectric capacitor may have different polarization states, for example, a "0" state or a "1" state. A charge Q0 is generated when an electric field is applied to the ferroelectric capacitor in the "0" state, a charge Q1 is generated when the same electric field is applied to the ferroelectric capacitor in the " 1" state, charges Q0 or charges Q1 accumulate and are converted into a read voltage, and data stored in the ferroelectric capacitor may be identified based on different read voltages.

FIG. 3 is a diagram of a ferroelectric memory of a single-transistor multi-capacitor (1 transistor n capacitor, 1TnC) structure according to an embodiment of this application. FIG. 3 shows a memory cell of the ferroelectric memory. The memory cell includes an access transistor T and a plurality of ferroelectric capacitors, and the access transistor T is disposed at an intersection of a word line (word line, WL) and a bit line (bit line, BL). A gate of the access transistor T is connected to the WL, a first terminal of the access transistor T is connected to the BL, a second terminal of the access transistor T is connected to first plates of a plurality of ferroelectric capacitors, and second plates of the ferroelectric capacitors each are connected to one plate line (plate line, PL).

The memory cell shown in FIG. 3 includes n ferroelectric capacitors: C1 to Cn, first plates of the ferroelectric capacitor C1 to the ferroelectric capacitor Cn are all connected to the second terminal of the access transistor T, and a common terminal of the ferroelectric capacitor C1 to the ferroelectric capacitor Cn is denoted as a floating gate (floating gate, FG). Second plates of the ferroelectric capacitor C1 to the ferroelectric capacitor Cn each are connected to one plate line, a second plate of the ferroelectric capacitor C1 is connected to a PL 1, a second plate of a ferroelectric capacitor C2 is connected to a PL 2, a second plate of a ferroelectric capacitor C3 is connected to a PL 3, and a second plate of the ferroelectric capacitor Cn is connected to a PL n. Each ferroelectric capacitor may store 1-bit (bit) data, and the memory cell includes n ferroelectric capacitors that can store n-bit data.

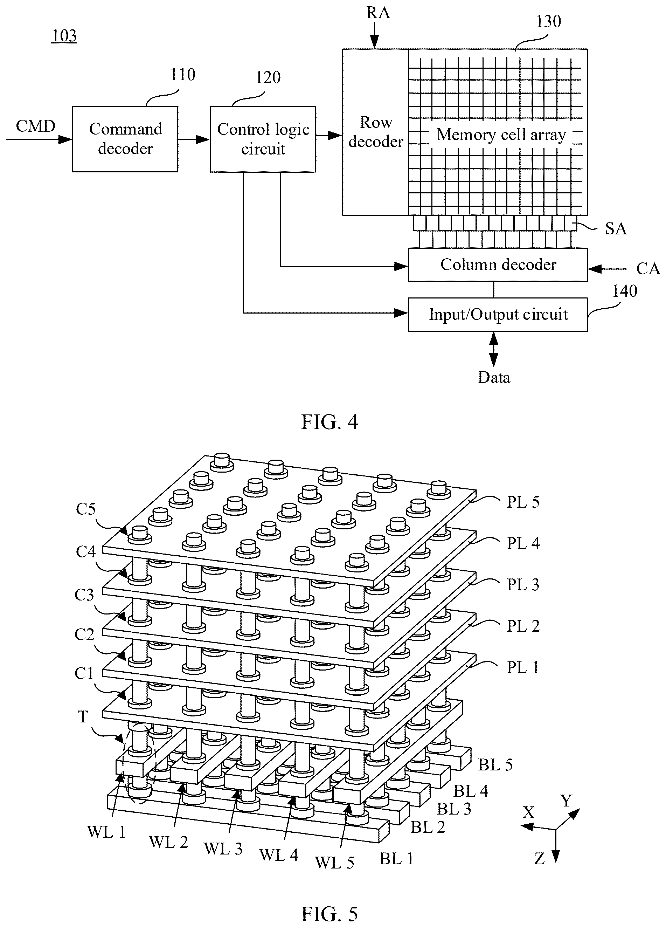

Usually, memory cells in the memory 103 are arranged and distributed into a matrix, the matrix is referred to as a memory cell array (array), and the matrix is referred to as a memory cell array (array). Refer to FIG. 4. The memory 103 may include a command decoder 110, a control logic circuit 120, a memory cell array 130, and an input/output circuit 140. Specific embodiments are not limited thereto, and fewer or more components may be included. The command decoder 110 may receive a command CMD (command, CMD) from the memory controller 102, and may decode the received command CMD, for example, a write command (write, WR) or a read command (read, RD). The memory controller 102 may locate any memory cell in the memory cell array by using a corresponding address line (word line, bit line, and plate line) decoder, that is, locate data of any bit.

The memory cell array 130 may include a plurality of memory cells. The plurality of memory cells may be connected to a plurality of word lines, a plurality of bit lines, and a plurality of plate lines. The word line may be connected to a word line control circuit, which is also referred to as a row decoder (row decoder), and the bit line may be connected to a bit line control circuit, which is also referred to as a column decoder (column decoder). The control logic circuit 120 may control the components of the memory 103 based on a decoding result from the command decoder 110. For example, when the decoding result of the command decoder 110 indicates that the received command CMD is an active command ACT, the control logic circuit 120 may control the word line control circuit to activate a word line corresponding to a row address (row address, RA) received together with the active command ACT, and apply excitation through a corresponding plate line. Then, data stored in the ferroelectric memory cell connected to the activated word line may be set (for example, transmitted, sent, or output) by using a sense amplifier (sense amplifier, SA) to the input/output circuit 140.

For example, when the decoding result of the command decoder 110 indicates that the received command CMD is a read command RD, the control logic circuit 120 may control the input/output circuit 140 to output data from a bit line corresponding to a column address (column address, CA) received together with the read command RD. When the decoding result of the command decoder 110 indicates that the received command CMD is a write command WR, the control logic circuit 120 may set write data received from the memory controller 102 to the input/output circuit 140. The memory controller 102 may send a precharge command PRE to the memory 103, to deactivate and/or disable the activated word line. For example, when the decoding result of the command decoder 110 indicates that the received command CMD is a precharge command PRE, the control logic circuit 120 may control the input/output circuit 140 and the bit line control circuit to precharge the bit line. The foregoing briefly describes basic principles of operations such as activation, read, write, and precharge. It may be understood that the operations such as activation, read, write, and precharge in the following solutions may be implemented in at least the manners described above.

FIG. 5 is a diagram of a structure of a ferroelectric memory according to an embodiment of this application. The ferroelectric memory includes one or more memory cell arrays, and FIG. 5 shows only a partial structure of a memory cell array. The memory cell array includes a plurality of bit lines: a BL 1 to a BL 5 that extend in a first direction, a plurality of word lines: a WL 1 to a WL 5 that extend in a second direction, and a plurality of plate lines: a PL 1 to a PL 5 that are stacked in a third direction. Herein, the first direction and the second direction intersect. For example, the first direction is orthogonal to the second direction, and the third direction is perpendicular to the first direction and the second direction. For example, the first direction may be an X direction of an XYZ coordinate system shown in FIG. 5, the second direction may be a Y direction in the figure, and the third direction may be a Z direction in the figure.

For example, the plurality of plate lines may be stacked in the third direction, and the plurality of ferroelectric capacitors may be stacked in the third direction of the access transistor T connected to the plurality of ferroelectric capacitors, to form a three-dimensional memory cell array. For example, still refer to FIG. 5. The plate lines, the ferroelectric capacitors, and the like may be stacked in the third direction. A first ferroelectric capacitor and a first plate line are located at a same layer, a second ferroelectric capacitor and a second plate line are located at a same layer, and the like, so that storage density of the memory is improved by stacking ferroelectric capacitors. For example, with reference to FIG. 5, a ferroelectric capacitor C1, a ferroelectric capacitor C2, a ferroelectric capacitor C3, a ferroelectric capacitor C4, and a ferroelectric capacitor C5 are stacked in the third direction of the access transistor 24. The ferroelectric capacitor C1 and the plate line PL 1 are located at a same layer, the ferroelectric capacitor C2 and the plate line PL 2 are located at a same layer, ..., and the ferroelectric capacitor C5 and the plate line PL 5 are located at a same layer. Ferroelectric capacitors located at a same layer are connected to a same plate line. In the memory cell array shown in FIG. 5, one access transistor T is connected to five ferroelectric capacitors, and in some other embodiments, each access transistor may be further connected to a larger quantity of ferroelectric capacitors.

The following describes a read/write principle of the ferroelectric memory based on the memory cell shown in FIG. 3. The word line WL is used to enable the access transistor T of the memory cell, and control the access transistor T to be conducted. The bit line BL and the plate line PL are used to charge the ferroelectric capacitor C of the memory cell, so that the ferroelectric capacitor C is in different polarization states (the polarization states shown in FIG. 2), and different polarization states of the ferroelectric capacitor C may be further used to represent data "0" and "1".

When data stored in a ferroelectric capacitor of the memory cell is read, for example, when data stored in the ferroelectric capacitor C1 is read, the word line WL is used to enable the access transistor T of the memory cell to be conducted, and the plate line PL 1 is used to apply an excitation voltage Vw to the ferroelectric capacitor C1 of the memory cell (the excitation voltage Vw is greater than the coercive field strength Ec of the ferroelectric material, and can reverse a polarization state of the ferroelectric capacitor). The ferroelectric capacitor C1 generates a reverse charge under application of the excitation voltage Vw, and determines read data based on a quantity of reverse charges. The reverse charges accumulate on the bit line BL to form a read voltage. When the bit line BL is at a low level, it indicates that the quantity of reverse charges is small. When bit line BL is at a high level, it indicates that the quantity of reverse charges is large. For example, when a large quantity of reverse charges is generated, it may indicate that data "1" is stored in the ferroelectric capacitor. When a quantity of reverse charges is small, it indicates that data "0" is stored. In another case, a large quantity of reverse charges may alternatively indicate that data "0" is stored, and a small quantity of reverse charges indicates that data "1" is stored. In this embodiment of this application, an example in which a large quantity of reverse charges indicates that data 1 is stored is used for description.

When a read operation is performed, a voltage of the word line WL is activated to conduct the access transistor T of the memory cell, and then the excitation voltage Vw is output to the plate line PL 1. A second plate of the ferroelectric capacitor C1 is connected to the plate line PL 1. After the excitation voltage Vw is applied to the second plate of the ferroelectric capacitor C1, a generated reverse charge is allocated to the bit line BL to form a read voltage on the bit line BL. With reference to FIG. 2, if data stored in the ferroelectric capacitor C1 is "1", the reverse charge "Q1" forms a read voltage on the bit line BL during reading. If data stored in the ferroelectric capacitor C1 is "0", the reverse charge "Q0" forms a read voltage on the bit line BL during reading.

In a read process, the excitation voltage Vw is applied to the second plate of the ferroelectric capacitor C1. If a voltage of the second plate of the ferroelectric capacitor C1 is different from the excitation voltage, which means that the excitation voltage Vw and the voltage of the second plate are in different states, for example, the excitation voltage is at a high level and the voltage of the second plate of the ferroelectric capacitor C1 is at a low level, a polarization state of the ferroelectric capacitor C1 may be reversed by applying the excitation voltage Vw to the second plate of the ferroelectric capacitor C1. In this case, a large quantity of reverse charges is generated, and data stored in the ferroelectric capacitor C1 is also rewritten. Therefore, in the read operation, the read data may further need to be written back to the ferroelectric capacitor, which is referred to as write-back.

With development of a process level of an integrated circuit, a storage capacity per unit area of the memory becomes larger, and an area of each memory cell is very small. Billions or even tens of billions of memory cells may be integrated on one memory chip, and each memory cell has only a size of dozens of nanometers. Consequently, when the ferroelectric capacitor of the memory cell releases reverse charges to the bit line, the voltage of the bit line can only be slightly changed, and the subtle voltage change may not be sensed. To accurately read the voltage of the bit line, a sense amplifier (sense amplifier, SA) is usually connected to the bit line, and the sense amplifier is configured to amplify a subtle voltage change on the bit line.

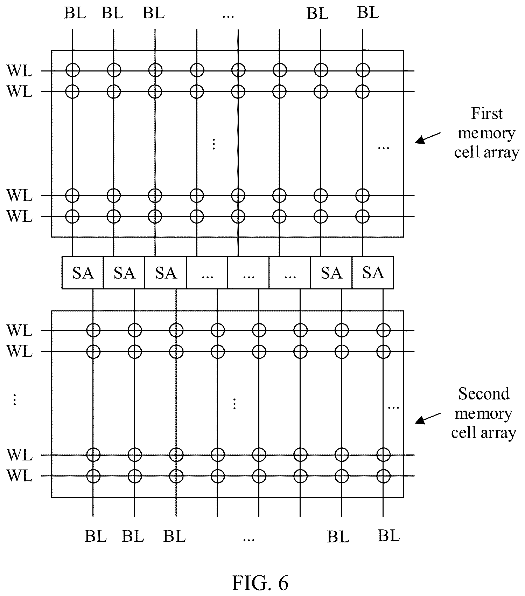

FIG. 6 is a diagram of application of a sense amplifier. The sense amplifier SA includes two input terminals that are respectively connected to two bit lines of two adjacent memory cell arrays. For example, a bit line BL (first bit line) in a first memory cell array is connected to a first input terminal of the sense amplifier SA, and a bit line BL (second bit line) in a second memory cell array is connected to a second input terminal of the sense amplifier SA. When data in a memory cell on the first bit line is accessed, the second bit line may be used as a reference. When data in a memory cell on the second bit line is accessed, the first bit line may be used as a reference. In this embodiment of this application, the to-be-accessed bit line is referred to as a bit line true BLT, and the bit line used as a reference is referred to as a bit line bar BLB or a reference bit line. Because structures of memory cells are all the same, the memory cell array is simplified as a diagram shown in FIG. 6 in which a word line and a bit line intersect. It may be understood that there is one memory cell at an intersection between each word line and each bit line. A plate line is not shown in FIG. 6.

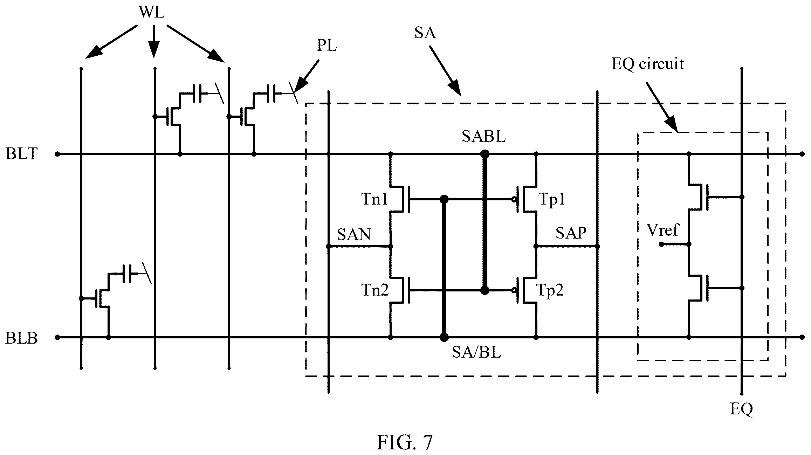

FIG. 7 is a diagram of a structure of a sense amplifier. The sense amplifier includes a first input terminal SABL, a second input terminal SA/BL, and four cross-connected transistors: two Nmos transistors Tn1 and Tn2 and two Pmos transistors Tp1 and Tp2. A first terminal of the Nmos transistor Tn1 is connected to the first input terminal SABL, a first terminal of the Nmos transistor Tn2 is connected to the second input terminal SA/BL, and a second terminal of the Nmos transistor Tn1 is connected to a second terminal of the Nmos transistor Tn2. A first terminal of the Pmos transistor Tp1 is connected to the first input terminal SABL, a first terminal of the Pmos transistor Tp2 is connected to the second input terminal SA/BL, and a second terminal of the Pmos transistor Tp1 is connected to a second terminal of the Pmos transistor Tp2. Gates of the Nmos transistor Tn1 and the Pmos transistor Tp1 are connected to the second input terminal SA/BL, and gates of the Nmos transistor Tn2 and the Pmos transistor Tp2 are connected to the first input terminal SABL.

When data in a memory cell on a bit line connected to the first input terminal SABL is read, the bit line connected to the first input terminal SABL may be referred to as a bit line true BLT, and a bit line connected to the second input terminal SA/BL of the sense amplifier may be referred to as a bit line bar BLB. Alternatively, when data in a memory cell on a bit line connected to the second input terminal SA/BL is read, the bit line connected to the second input terminal SA/BL is referred to as a bit line true BLT, and a bit line connected to the first input terminal SABL is referred to as a bit line bar BLB. The bit line true BLT and the bit line bar BLB form a bit line pair. When data is read, an access transistor of a memory cell connected to the bit line bar BLB is not conducted. Therefore, a voltage change on the bit line bar BLB does not affect the memory cell connected to the bit line bar BLB. The bit line true BLT and the bit line bar BLB shown in FIG. 6 are from two different memory cell arrays. In some other implementations, the bit line true BLT and the bit line bar BLB may be from a same memory cell array.

With reference to FIG. 7, the sense amplifier further includes an equalization (equalization, EQ) circuit, the EQ circuit is controlled by an equalization (equalization, EQ) signal, and the EQ circuit includes two transistors controlled by the EQ signal. One terminal of each of the two transistors is connected to a reference signal terminal, and the other terminals of the two transistors are respectively connected to the bit line true BLT and the bit line bar BLB. When the EQ signal is used to enable the two transistors in the EQ circuit to be conducted, the two transistors may be used for conduction between the reference signal terminal and both the bit line true BLT and the bit line bar BLB, and charge voltages of the bit line true BLT and the bit line bar BLB to a reference voltage Vref. The EQ circuit can ensure that voltages of a bit line pair (for example, the bit line true BLT and the bit line bar BLB) connected to the sense amplifier are the same as much as possible. In this way, when the voltages of the bit line pair are different, the sense amplifier may be configured to amplify a difference between the voltages of the bit line pair.

A core of the sense amplifier is the four cross-connected transistors. The four cross-connected transistors form a bistable circuit, and the bistable circuit may be referred to as a sense amplification circuit. The sense amplifier uses the EQ circuit to precharge the voltages of the bit line pair (the bit line true BLT and the bit line bar BLB) to the reference voltage. Then, when conduction between the ferroelectric capacitor of the memory cell and the bit line is performed by using the access transistor, the ferroelectric capacitor releases a reverse charge under application of the excitation voltage Vw, and the reverse charge is shared with the bit line true BLT. Because an area of the ferroelectric capacitor is small, and capacitance of the bit line is larger than that of the ferroelectric capacitor, sharing the reverse charge with the bit line true BLT may cause a subtle change on the voltage of the bit line true BLT. The sense amplifier may sense a subtle difference between the voltages of the bit line true BLT and the bit line bar BLB, and under an action of the subtle difference between the voltages of the bit line pair, drive the voltages of the bit line true BLT and the bit line bar BLB to reach two opposite extreme values, for example, drive the voltage of the bit line true BLT to a high level (indicating that data in the memory cell is 1), and drive the voltage of the bit line bar BLB to a low level; or drive the voltage of the bit line true BLT to a low level (indicating that data in the memory cell is 0), and drive the voltage of the bit line bar BLB to a high level. Usually, the high level is a power supply voltage Vcc (1 V), and the low level is a ground voltage Vss (0 V).

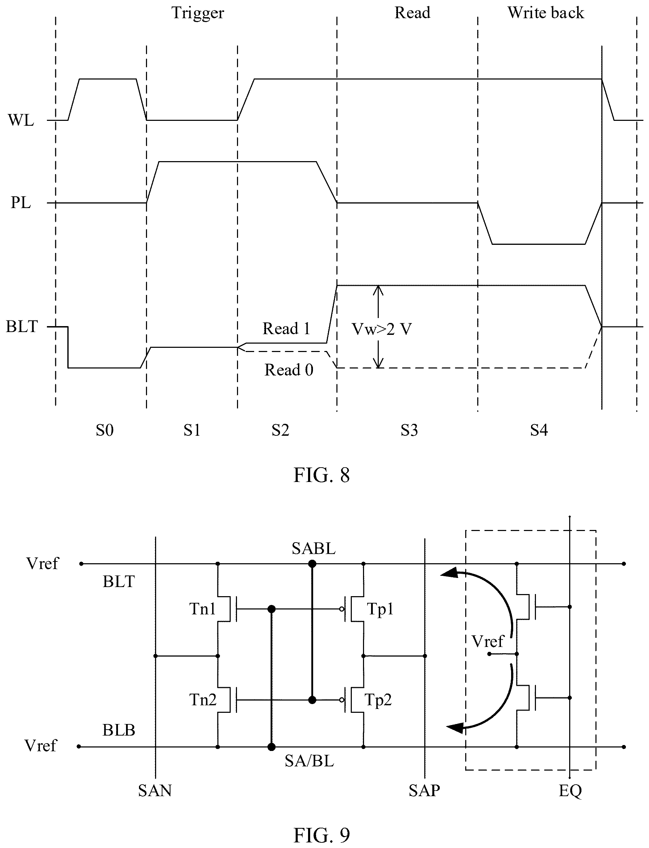

FIG. 8 is a timing diagram of a read operation of a ferroelectric memory. The read operation of the ferroelectric memory usually includes three stages: trigger, read, and write-back. The following briefly describes a working principle of the sense amplifier based on the three stages of the read operation of the ferroelectric memory.

The trigger stage includes three sub-stages: S0, S1, and S2.

S0. Floating gate precharge (FG precharge): The word line WL is activated, the voltage of the bit line true BLT is reduced to Vss, a voltage of a floating gate (FG) is reduced to Vss by the bit line true BLT, and then the word line WL is disabled. In this case, the voltage of the floating gate is Vss. For example, Vss may be 0 V. Floating gate precharge may release a charge remaining in the floating gate in a previous read or write process, to prevent accuracy of data reading from being affected.

S1. Destroy (destroy): The word line WL is disabled, a voltage of the plate line PL is increased to the excitation voltage Vw, and the excitation voltage is applied to the ferroelectric capacitor, to trigger reversal of the polarization state of the ferroelectric capacitor (or destroy the polarization state of the ferroelectric capacitor), and release the reverse charge to the floating gate.

With reference to FIG. 9, in the destroy stage, the EQ circuit is conducted, and the voltages of the bit line true BLT and the bit line bar BLB are charged to the reference voltage Vref. The reference voltage may be an intermediate voltage between a voltage of the floating gate when the ferroelectric capacitor releases a large quantity of reverse charges to the floating gate and a voltage of the floating gate when the ferroelectric capacitor releases a small quantity of reverse charges to the floating gate.

S2. Sense (sense): The word line WL is activated again, to enable the access transistor to be conducted. The charge released by the ferroelectric capacitor to the floating gate is shared with the bit line true BLT by using the access transistor, so that the voltage of the bit line true BLT slightly changes. If a quantity of reverse charges is large, the voltage of the bit line true BLT is slightly increased. For example, the voltage of the bit line true BLT changes to Vref+. If a quantity of reverse charges is small, the voltage of the bit line true BLT is slightly reduced. For example, the voltage of the bit line true BLT changes to Vref-.

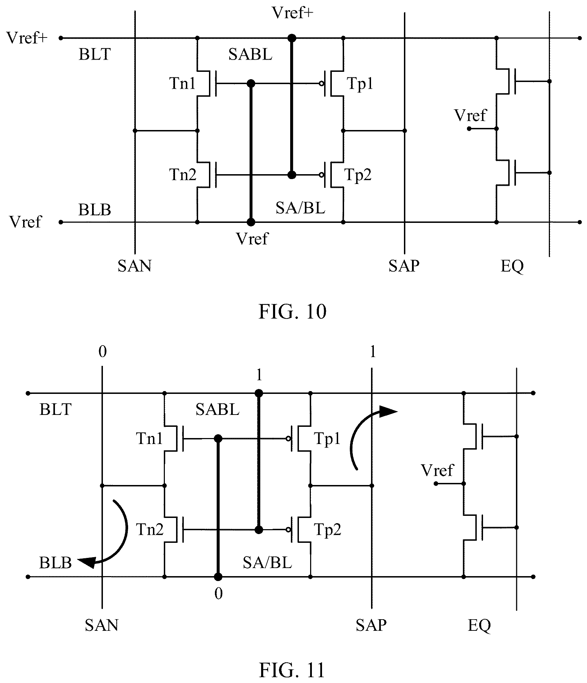

Refer to FIG. 10. An example in which the voltage of the bit line true BLT is increased to Vref+ is used, and the voltage of the bit line bar BLB does not change and is still Vref. In this way, both a voltage of the first input terminal SABL of the sense amplifier and the voltage of the bit line true BLT are Vref+, and both a voltage of the second input terminal SA/BL and the voltage of the bit line bar BLB are Vref. The first input terminal SABL is connected to gates of the Nmos transistor Tn2 and the Pmos transistor Tp2, and the second input terminal SA/BL is connected to the gates of the Nmos transistor Tn1 and the Pmos transistor Tp1. The subtle difference between the voltages of the bit line true BLT and the bit line bar BLB makes a voltage of the gate of the Nmos transistor Tn2 higher than a voltage of the gate of the Nmos transistor Tnl, which drives the Nmos transistor Tn2 to be more conductive than the Nmos transistor Tn1. The subtle difference between the voltages of the bit line true BLT and the bit line bar BLB makes a voltage of the gate of the Pmos transistor Tp2 higher than a voltage of the gate of the Pmos transistor Tp 1, which drives the Pmos transistor Tp2 to be less conductive than the Pmos transistor Tp1.

In the sensing stage, with reference to FIG. 11, a sense-amplifier N-type field effect transistor control (sense-amplifier N-FET control, SAN) sensing signal connected to a first power supply terminal SAN of the sense amplifier is activated, and a P-type field effect transistor control (sense-amplifier P-FET control, SAP) sensing signal connected to a second power supply terminal SAP is activated. The first power supply terminal SAN is connected to the second terminal of the Nmos transistor Tn1 and the second terminal of the Nmos transistor Tn2. The second power supply terminal SAP is connected to the second terminal of the Pmos transistor Tp1 and the second terminal of the Pmos transistor Tp1.

The signal of the first power supply terminal SAN may control activation of the Nmos transistor of the sense amplifier, and the signal of the second power supply terminal SAP may control activation of the Pmos transistor of the sense amplifier. Usually, the signal of the first power supply terminal SAN is at a low level representing 0, for example, Vss. The signal of the second power supply terminal SAP is at a high level representing 1, for example, Vcc.

Because the Nmos transistor Tn2 is more conductive than the Nmos transistor Tn1 under the action of the subtle difference between the voltages of the bit line true BLT and the bit line bar BLB, under the action of the signal of the first power supply terminal SAN, a voltage of the first power supply terminal SAN may cause the voltage of the second input terminal SA/BL to be lower than Vref through the Nmos transistor Tn2. Because the Pmos transistor Tp2 is less conductive than the Pmos transistor Tp1, under the action of the signal of the second power supply terminal SAP, a voltage of the second power supply terminal SAP may cause the voltage of the first input terminal SABL to be higher than Vref+ through the Pmos transistor Tp1. In this case, the voltage of the second input terminal SA/BL is reduced, and the voltage of the first input terminal SABL is increased, which makes the Nmos transistor Tn2 more conductive than the Nmos transistor Tnl, and makes the Pmos transistor Tp2 less conductive than the Pmos transistor Tp1, until a stable state in which the Nmos transistor Tn2 is conducted, the Nmos transistor Tn1 is cut off, the Pmos transistor Tp1 is conducted, and the Pmos transistor Tp2 is cut off is reached. In this case, the first input terminal SABL conducts electricity with the second power supply terminal SAP, to drive the voltage of the first input terminal SABL to be the same as a voltage of the signal of the second power supply terminal SAP, that is, the high level Vcc representing 1; and the second input terminal SA/BL conducts electricity with the first power supply terminal SAN, to drive the voltage of the second input terminal SA/BL to be the same as a voltage of the first power supply terminal SAN, that is, the low level Vss representing 0. In this way, the subtle difference between the voltage (Vref+) of the bit line true BLT and the voltage (Vref) of the bit line bar BLB is amplified to a state difference between two voltage extreme values: Vcc and Vss.

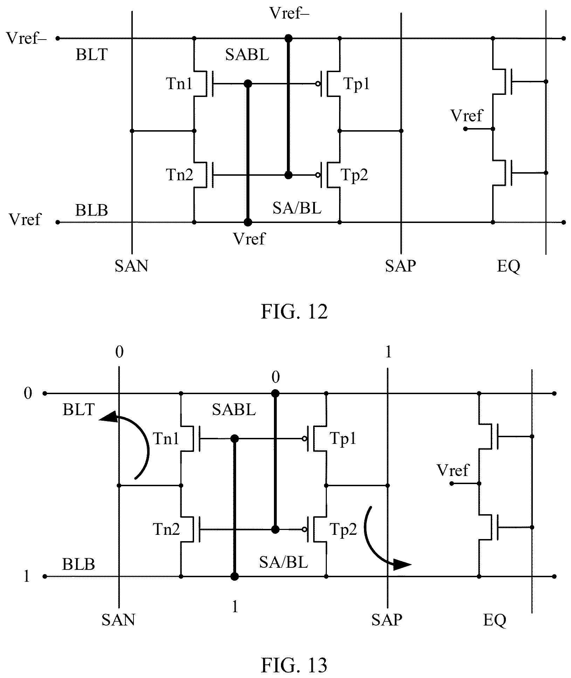

In the foregoing example, a quantity of reverse charges is large, and the voltage of the bit line true BLT is increased. On the contrary, refer to FIG. 12, if a quantity of reverse charges generated in the trigger stage is small, and the voltage of the floating gate is lower than the voltage of the bit line true BLT, charge sharing causes the voltage of the bit line true BLT to be slightly lower than the reference voltage Vref. In this case, the voltage of the bit line true BLT is reduced to Vref-, but the voltage of the bit line bar BLB does not change and is still Vref. The subtle difference between the voltages of the bit line true BLT and the bit line bar BLB makes the voltage of the gate of the Nmos transistor Tn2 lower than the voltage of the gate of the Nmos transistor Tn1, which drives the Nmos transistor Tn2 to be less conductive than the Nmos transistor Tn1. The subtle difference between the voltages of the bit line true BLT and the bit line bar BLB makes the voltage of the gate of the Pmos transistor Tp2 lower than the voltage of the gate of the Pmos transistor Tp 1, which drives the Pmos transistor Tp2 to be more conductive than the Pmos transistor Tp1.

In the sensing stage, refer to FIG. 13, because the Nmos transistor Tn2 is less conductive than the Nmos transistor Tn1 under the action of the subtle difference between the voltages of the bit line true BLT and the bit line bar BLB, under the action of the signal of the first power supply terminal SAN, the voltage of the first power supply terminal SAN may cause the voltage of the first input terminal SABL to be lower than Vref- through the Nmos transistor Tn1. Because the Pmos transistor Tp2 is more conductive than the Pmos transistor Tp 1, under the action of the signal of the second power supply terminal SAP, the voltage of the second power supply terminal SAP may cause the voltage of the second input terminal SA/BL to be higher than Vref through the Pmos transistor Tp2. In this case, the voltage of the first input terminal SABL is reduced, and the voltage of the second input terminal SA/BL is increased, which makes the Nmos transistor Tn2 less conductive than the Nmos transistor Tnl, and makes the Pmos transistor Tp2 more conductive than the Pmos transistor Tp1, until a stable state in which the Nmos transistor Tn1 is conducted, the Nmos transistor Tn2 is cut off, the Pmos transistor Tp2 is conducted, and the Pmos transistor Tp1 is cut off is reached. In this case, the first input terminal SABL conducts electricity with the first power supply terminal SAN, to drive the voltage of the first input terminal SABL to be the same as the voltage of the first power supply terminal SAN, that is, the low level Vss representing 0; and the second input terminal SA/BL conducts electricity with the second power supply terminal SAP, to drive the voltage of the second input terminal SA/BL to be the same as the voltage of the second power supply terminal SAP, that is, the high level Vcc representing 1. In this way, the subtle difference between the voltage (Vref-) of the bit line true BLT and the voltage (Vref) of the bit line bar BLB is amplified to a state difference between two voltage extreme values: Vss and Vcc.

In the sensing stage, the sense amplifier amplifies the difference between the voltages of the bit line true BLT and the bit line bar BLB. If the ferroelectric capacitor releases a large quantity of reverse charges, the voltage of the bit line true BLT is higher than the voltage of the bit line bar BLB. Finally, the sense amplifier increases the voltage of the bit line true BLT to the voltage Vcc representing the data 1, where Vcc is a voltage of the signal of the second power supply terminal SAP of the sense amplifier; and reduces the voltage of the bit line bar BLB to the voltage Vss representing the data 0, where Vss is a voltage of the signal of the first power supply terminal SAN of the sense amplifier. If the ferroelectric capacitor releases a small quantity of reverse charges, the voltage of the bit line true BLT is lower than the voltage of the bit line bar BLB. Finally, the sense amplifier reduces the voltage of the bit line true BLT to Vss, and increases the voltage of the bit line bar BLB to Vcc.

In the read stage, for example, the S3 stage shown in FIG. 8, the sense amplifier has increased or reduced the voltage of the bit line true BLT, so that data stored in the ferroelectric capacitor can be read by detecting the voltage (or a current) of the bit line true BLT.

In the write-back stage, for example, the S4 stage shown in FIG. 8, after data is read, the read data is written again to avoid rewriting data in the memory cell in the read process. Therefore, this process is referred to as write-back. The write-back stage is actually a data write process. When the ferroelectric capacitor releases a large quantity of reverse charges, it indicates that the polarization state of the ferroelectric capacitor is reversed, and the stored data is rewritten. In this case, the read data needs to be written into the ferroelectric capacitor again.

With reference to the descriptions of the sensing stage in the foregoing example, in a data sensing process, the bit line pair provides an initial voltage angle, the sense amplifier amplifies a subtle difference of voltages between the bit line pair, and the finally presented voltage difference is a voltage difference between a voltage Vss that represents 0 and that is provided by the first power supply terminal SAN and a voltage Vcc that represents 1 and that is provided by the second power supply terminal SAP.

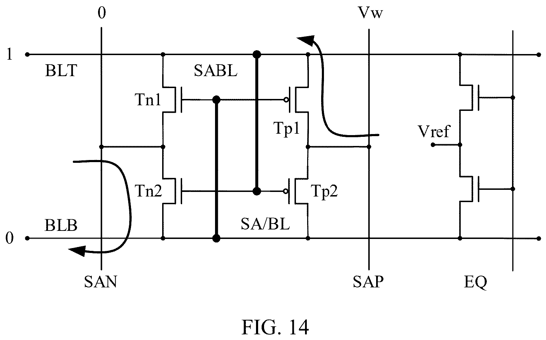

With reference to FIG. 8 and FIG. 14, in the write-back process, which is a reverse process of the sensing process, input drivers respectively corresponding to the two bit lines BLT and BLB provide an initial voltage angle for the sense amplifier, after a state of the sense amplifier is stable, the excitation voltage Vw provided by the second power supply terminal SAP is applied to the bit line true BLT, and the voltage of the plate line PL is reduced, so that the polarization state of the ferroelectric capacitor is restored to a state before the trigger stage. In this way, the write-back is completed.

It can be learned based on the content of the foregoing example that, in the read operation of the ferroelectric memory, the excitation voltage Vw needs to be applied to the ferroelectric capacitor in both the trigger stage and the write-back stage, and the excitation voltage Vw is greater than a voltage Vc of a coercive electric field of the ferroelectric capacitor. In the trigger stage, an excitation voltage Vw is applied to the ferroelectric capacitor through the plate line. In the write-back stage, the sense amplifier increases the voltage of the bit line true BLT to Vw. To implement high sensitivity of sensing the voltage difference, the transistor in the sense amplifier usually uses a thin gate device. The thin gate device is sensitive to a subtle voltage difference, but is not resistant to a high voltage, and a withstand voltage range is approximately below 1.2 V. However, in the ferroelectric memory, because the ferroelectric material has a spontaneous polarization feature, the excitation voltage Vw that exceeds the voltage Ec of the coercive field needs to be applied to the ferroelectric capacitor, so that the polarization state of the ferroelectric capacitor can be reversed. Usually, the excitation voltage Vw is a voltage greater than 2 V.

Based on the content in the foregoing example, in the data read process and the write-back process, the signal provided by the first power supply terminal SAN is transmitted to the first input terminal SABL or the bit line true BLT through the Nmos transistor Tnl, and the signal provided by the second power supply terminal SAP is transmitted to the second input terminal SA/BL or the bit line bar BLB through the Pmos transistor Tp2. Alternatively, the signal provided by the first power supply terminal SAN is transmitted to the second input terminal SA/BL or the bit line bar BLB through the Nmos transistor Tn2, and the signal provided by the second power supply terminal SAP is transmitted to the first input terminal SABL or the bit line true BLT through the Pmos transistor Tp1.

In the write-back operation of the ferroelectric memory, the sense amplifier increases the voltage of the bit line true BLT to Vw based on the voltage of the second power supply terminal SAP. In this case, the second power supply terminal SAP needs to provide a signal whose voltage is Vw. However, a voltage of the signal provided by the first power supply terminal SAN of the sense amplifier is usually Vss (0 V). Consequently, a plurality of transistors in the sense amplifier withstand a large voltage difference (Vw-Vss, greater than 2 V), which exceeds the withstand voltage range of the thin gate device. If the transistor in the sense amplifier uses a thick gate device, the thick gate device has a larger withstand voltage range, and has a maximum withstand voltage of about 3.3 V. However, the thick gate device is insensitive to a subtle voltage difference, and may not sense a subtle difference between voltages of a bit line pair in the sensing stage, resulting in an error in reading data. Consequently, a current sense amplifier cannot implement both high-sensitivity detection and high-voltage write-back.

In view of this, an embodiment of this application provides a memory. For example, the memory may be a ferroelectric memory, or another memory having low-voltage read and high-voltage write-back features. The memory provided in embodiments of this application uses a new sense amplifier solution design, to resolve a problem that the existing sense amplifier cannot implement both high-sensitivity detection and high-voltage write-back.

For example, an embodiment of this application provides a memory. The memory includes a memory cell array and a sense amplifier, the memory cell array includes a first bit line and a second bit line, the sense amplifier includes a sense amplification circuit, a first switch circuit, and a second switch circuit, and the sense amplification circuit includes a first input terminal, a second input terminal, a first power supply terminal, and a second power supply terminal. The first input terminal is connected to the first bit line, the second input terminal is connected to the second bit line, the first power supply terminal is connected to the first switch circuit, and the second power supply terminal is connected to the second switch circuit. The first switch circuit is configured to switch the first power supply terminal between conducting electricity with a first power supply and conducting electricity with a second power supply, where a voltage of the second power supply is greater than a voltage of the first power supply. The second switch circuit is configured to switch the second power supply terminal between conducting electricity with a third power supply and conducting electricity with a fourth power supply, where a voltage of the fourth power supply is greater than a voltage of the third power supply.

It can be learned from the content in the foregoing example that the sense amplifier including the thin gate device cannot withstand a large voltage difference, but the memory like the ferroelectric memory requires a high bit line voltage to write back data. In the memory provided in embodiments of this application, voltages of the first power supply terminal and the second power supply terminal of the sense amplification circuit at different working stages of the sense amplifier may be adjusted. For example, in a sensing stage of data reading, Vss (for example, 0 V) is applied to the first power supply terminal, and Vcc (for example, 1 V) is applied to the second power supply terminal, to amplify a voltage angle and amplify a subtle difference between voltages of a bit line pair. In a write-back stage, the voltage applied to the second power supply terminal may be switched to Vw to meet a voltage requirement for writing back data, and a voltage of a signal connected to the first power supply terminal is also increased, so that a difference between voltages of signals provided by the second power supply terminal and the first power supply terminal is maintained within a withstand voltage range of the thin gate device. Therefore, in the write-back stage, the sense amplifier is not damaged because a difference between voltages of the second power supply terminal and the first power supply terminal is excessively large and exceeds the withstand voltage range of the thin gate device.

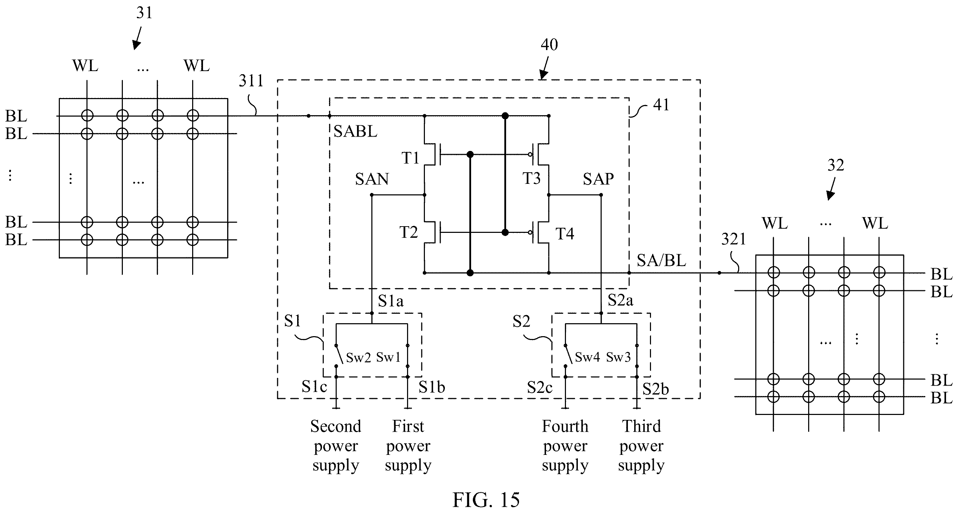

For example, the memory may include a plurality of memory cell arrays, and the first bit line and the second bit line may be located in different memory cell arrays. For example, with reference to FIG. 15, the memory includes a first memory cell array 31 and a second memory cell array 32, and the first memory cell array 31 and the second memory cell array 32 each include a plurality of memory cells, which means that the first memory cell array 31 and the second memory cell array 32 each include a plurality of word lines, a plurality of bit lines, and a plurality of plate lines. A first bit line 311 is located in the first memory cell array 31, and a second bit line 321 is located in the second memory cell array 32. In some other possible implementations, the first bit line 311 and the second bit line 321 may alternatively be located in a same memory cell array.

A sense amplifier 40 includes a sense amplification circuit 41, a first switch circuit S1, and a second switch circuit S2. The sense amplification circuit 41 includes a first input terminal SABL, a second input terminal SA/BL, a first power supply terminal SAN, a second power supply terminal SAP, and four transistors: a first transistor T1, a second transistor T2, a third transistor T3, and a fourth transistor T4. The first input terminal SABL is connected to the first bit line 311, and the second input terminal SA/BL is connected to the second bit line 321. A read operation is used as an example. When a memory cell on the first bit line 311 is accessed, the first bit line 311 may be used as a bit line true, and the second bit line 321 may be used as a bit line bar. When a memory cell on the second bit line 321 is accessed, the second bit line 321 may be used as a bit line true, and the first bit line 311 may be used as a bit line bar.

A first terminal of the first transistor T1 is connected to the first input terminal SABL, a first terminal of the second transistor T2 is connected to the second input terminal SA/BL, a second terminal of the first transistor T1 and a second terminal of the second transistor T2 are coupled and connected to the first power supply terminal SAN, a gate of the first transistor T1 is connected to the second input terminal SA/BL, and a gate of the second transistor T2 is connected to the first input terminal SABL.

A first terminal of the third transistor T3 is connected to the first input terminal SABL, a first terminal of the fourth transistor T4 is connected to the second input terminal SA/BL, a second terminal of the third transistor T3 and a second terminal of the fourth transistor T4 are coupled and connected to the second power supply terminal SAP, a gate of the third transistor T3 is connected to the second input terminal SA/BL, and a gate of the fourth transistor T4 is connected to the first input terminal SABL.

The first transistor T1 and the second transistor T2 are Nmos transistors, and the third transistor T3 and the fourth transistor T4 are Pmos transistors. The first transistor T1, the second transistor T2, the third transistor T3, and the fourth transistor T4 are thin gate devices. The thin gate device is sensitive to a subtle voltage change, and can sensitively sense a subtle voltage difference. The first transistor T1 and the third transistor T3 may form a first inverter, the second transistor T2 and the fourth transistor T4 may form a second inverter, and the first inverter and the second inverter are connected in a head-to-tail manner, to increase or reduce voltages of the first bit line 311 and the second bit line 321 to two different states. For example, the voltage of the first bit line 311 is increased, and the voltage of the second bit line 321 is reduced; or the voltage of the first bit line 311 is reduced, and the voltage of the second bit line 321 is increased.

For example, with reference to FIG. 15, the first input terminal SABL is configured to connect to the first bit line 311, to read data in a memory cell connected to the first bit line 311, or write data into the memory cell connected to the first bit line 311. The second input terminal SA/BL is configured to connect to the second bit line 321, and is used as a reference for reading data or writing data. The first power supply terminal SAN is configured to connect to a low-level power signal, where the low-level power signal herein may be used as an N-type field effect transistor control (sense-amplifier n-fet control, SAN) signal of the sense amplifier 40. The second power supply terminal SAP is configured to connect to a high-level power signal, where the high-level power signal herein may be used as a P-type field effect transistor control (sense-amplifier p-fet control, SAP) signal of the sense amplifier 40. For example, the first power supply terminal SAN is connected to a first switch circuit S1, the second power supply terminal SAP is connected to a second switch circuit S2, the first switch circuit S1 is configured to switch the first power supply terminal SAN between conducting electricity with the first power supply and conducting electricity with the second power supply, and the second switch circuit S2 is configured to switch the second power supply terminal SAP between conducting electricity with the third power supply and conducting electricity with the fourth power supply.

In a possible implementation, the sense amplifier 40 may work in a first working state and a second working state. In the first working state, the first switch circuit S1 is configured for the first power supply terminal SAN to conduct electricity with the first power supply, and the second switch circuit S2 is configured for the second power supply terminal SAP to conduct electricity with the third power supply. In the second working state, the first switch circuit S1 is configured for the first power supply terminal SAN to conduct electricity with the second power supply, and the second switch circuit S2 is configured for the second power supply terminal SAP to conduct electricity with the third power supply. The two different working states may correspond to different working environments of the sense amplifier 40. In a stage like a sensing stage of an access process of the memory, the first switch circuit S1 and the second switch circuit S2 select to connect to the first power supply and the third power supply. In a stage like a write-back stage, the first switch circuit S1 and the second switch circuit S2 select to connect to the second power supply and the fourth power supply.

For example, in different stages of an access operation of the memory, a control logic circuit may control the sense amplifier 40 to work in the first working state or the second working state, so that the first power supply terminal SAN and the second power supply terminal SAP are connected to different power supplies. When the sense amplifier is in a non-write stage, for example, in a trigger (precharge, destroy, sense, and the like) stage of a read or write operation, the sense amplifier 40 may work in the first working state, the first switch circuit S1 is for the first power supply terminal SAN to conduct electricity with the first power supply, and the second switch circuit S2 is for the second power supply terminal SAP to conduct electricity with the third power supply, where a difference between voltages of the third power supply and the first power supply falls within a withstand voltage range of the thin gate device used by the sense amplifier 40. For example, in the sensing stage, the sense amplification circuit 41 amplifies a subtle difference between voltages of the first bit line 311 and the second bit line 321 into a difference between voltages of the third power supply and the first power supply. For example, to ensure that data can be read, a voltage of the third power supply may be Vcc (for example, 1 V), and a voltage of the first power supply may be Vss (for example, 0 V).

In the sensing stage, if a voltage of the first bit line 311 is slightly higher than a voltage of the second bit line 321 after charge sharing, the sense amplifier 40 increases the voltage of the first bit line 311 to Vcc, reduces the voltage of the second bit line 321 to Vss, so that data in the memory cell can be read by reading a high level from the first bit line 311. Alternatively, if the voltage of the first bit line 311 is slightly lower than the voltage of the second bit line 321 after charge sharing, the sense amplifier 40 reduces the voltage of the first bit line 311 to Vss, and increases the voltage of the second bit line 321 to Vcc, so that data in the memory cell can be read by reading a low level from the first bit line 311.

In this stage, the voltages of the third power supply and the first power supply only need to be distinguished as a high level or a low level, and can be read. Therefore, the third power supply may be a low voltage Vcc, and the first power supply may be Vss.

When the sense amplifier is in the write stage, for example, in the write-back stage of the read operation or the write stage of the write operation, to meet a voltage requirement of writing data at a high voltage, the sense amplifier 40 may work in the second working state, the second switch circuit S2 is for the second power supply terminal SAP to conduct electricity with the fourth power supply whose voltage is higher than the voltage of the third power supply, and the first switch circuit S1 is for the first power supply terminal SAN to conduct electricity with the second power supply whose voltage is higher than the voltage of the first power supply, where a difference between voltages of the fourth power supply and the second power supply does not exceed the withstand voltage range of the thin gate device.

In the write-back stage, the ferroelectric memory is used as an example. If a polarization state of a ferroelectric capacitor is reversed in the trigger stage, and data stored in the ferroelectric capacitor is rewritten, in the write-back stage, the polarization state of the ferroelectric capacitor needs to be reversed back to the state before the trigger stage, and the data is written back to the ferroelectric capacitor. In this case, an excitation voltage Vw that exceeds a voltage Ec of a coercive field needs to be applied, to reverse the polarization state of the ferroelectric capacitor, and the excitation voltage Vw is usually greater than 2 V due to a feature of the ferroelectric material.

In the write-back stage, the write voltage applied by the bit line to the ferroelectric capacitor is provided by the first power supply terminal SAN or the second power supply terminal SAP of the sense amplification circuit. The first power supply terminal SAN may be configured to provide a low level, and the second power supply terminal SAP may be configured to provide a high level. In this case, if the excitation voltage Vw that exceeds the voltage Ec of the coercive field needs to be applied to the ferroelectric capacitor in the write-back stage, that is, the voltage of the first bit line 311 needs to be increased to Vw based on the signal of the second power supply terminal SAP, the second power supply terminal SAP needs to be connected to a power supply whose voltage is higher than the voltage of the third power supply. In this embodiment of this application, in the write-back stage, the second power supply terminal SAP is connected to the fourth power supply, and the voltage of the fourth power supply is a high voltage required for writing back data. The ferroelectric memory is used as an example, and the voltage of the fourth power supply may be the excitation voltage Vw required by the ferroelectric capacitor. To ensure that the difference between voltages of the second power supply terminal SAP and the first power supply terminal SAN does not exceed the withstand voltage range of the thin gate device used by the sense amplifier 40, when the second switch circuit S2 switches the second power supply terminal SAP from being connected to the third power supply to being connected to the fourth power supply at a higher voltage, the first power supply terminal SAN also needs to be connected to a power supply at a higher voltage. In this embodiment of this application, when the second power supply terminal SAP is connected to the fourth power supply, the first switch circuit S1 connects the first power supply terminal SAN to the second power supply. On a premise of ensuring that the difference between voltages of the fourth power supply and the second power supply does not exceed the withstand voltage range of the thin gate device, the voltage of the second power supply may be any power supply voltage between 0 and the voltage of fourth power supply, for example, the voltage of the fourth power supply is Vw, and the voltage of the second power supply may be Vw/2.

It can be learned from the foregoing content that the first power supply terminal SAN and the second power supply terminal SAP have two working states. In one working state, the first power supply terminal SAN is connected to the first power supply, and the second power supply terminal SAP is connected to the third power supply. In the other working state, the first power supply terminal SAN is connected to the second power supply, and a third control terminal SAP is connected to the fourth power supply. The voltage of the fourth power supply is higher than the voltage of the second power supply, and the voltage of the fourth power supply is higher than the voltage of the third power supply. In a possible implementation, the voltage of the second power supply may be the same as the voltage of the third power supply.

In a possible implementation, the first switch circuit S1 includes a first switch Sw1, a second switch Sw2, a first common terminal S1a, a first selection terminal S1b, and a second selection terminal Slc, the first common terminal S1a is connected to the first power supply terminal SAN, the first selection terminal S1b is connected to the first power supply, the second selection terminal S1c is connected to the second power supply, the first switch Sw1 is connected between the first selection terminal S1b and the first common terminal S1a, and the second switch Sw2 is connected between the second selection terminal S1c and the first common terminal S1a. The second switch circuit S2 includes a third switch Sw3, a fourth switch Sw4, a second common terminal S2a, a third selection terminal S2b, and a fourth selection terminal S2c, the second common terminal S2a is connected to the second power supply terminal SAP, the third selection terminal S2b is connected to the third power supply, the fourth selection terminal S2c is connected to the fourth power supply, the third switch Sw3 is connected between the third selection terminal S2b and the second common terminal S2a, and the fourth switch Sw4 is connected between the fourth selection terminal S2c and the second common terminal S2a.

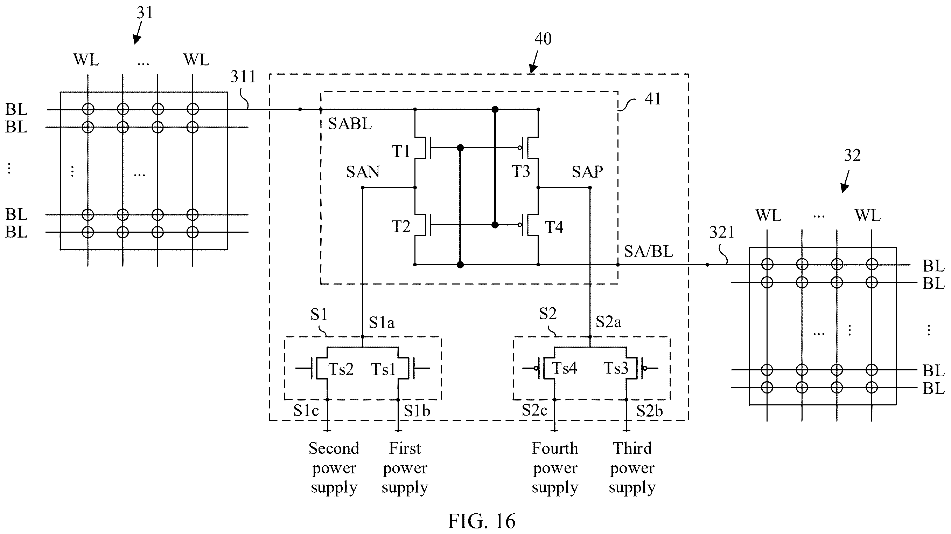

Refer to FIG. 16. The first switch Sw1, the second switch Sw2, the third switch Sw3, and the fourth switch Sw4 may be implemented by transistors. For example, the first switch Sw1 includes a transistor Ts1, the second switch Sw2 includes a transistor Ts2, and the transistor Ts1 and the transistor Ts2 each include a first terminal, a second terminal, and a gate. The first terminal of the transistor Ts1 is connected to the first power supply terminal SAN, the second terminal of the transistor Ts1 is connected to the first power supply, and the gate of the transistor Ts1 is configured to connect to a first control signal, and switch conduction states of the first terminal and the second terminal based on the first control signal. The first terminal of the transistor Ts2 is connected to the first power supply terminal SAN, the second terminal of the transistor Ts2 is connected to the second power supply, and the gate of the transistor Ts2 is configured to connect to a second control signal, and switch conduction states of the first terminal and the second terminal based on the second control signal. For example, when the access operation of the memory enters the sensing stage, the first control signal is used to enable the transistor Ts1 to be conducted, the second control signal is used to enable the transistor Ts2 to be cut off, and the first power supply terminal SAN conducts electricity with the first power supply through the transistor Ts1. When the access operation enters the write-back stage, the first control signal is used to enable the transistor Ts1 to be cut off, the second control signal is used to enable the transistor Ts2 to be conducted, and the first power supply terminal SAN conducts electricity with the second power supply through the transistor Ts2.

In a possible implementation, the transistor Ts1 and the transistor Ts2 may be transistors of a same type, for example, both are Nmos transistors or both are Pmos transistors. In some other possible implementations, the transistor Ts1 and the transistor Ts2 may be different types of transistors. For example, the transistor Ts1 is an Nmos transistor, and the transistor Ts2 is a Pmos transistor. Because the Nmos transistor is conducted when a voltage of the gate is at a high level, and the Pmos transistor is conducted when a voltage of the gate is at a low level, the first control signal of the transistor Ts1 and the second control signal of the transistor Ts2 may be a same control signal.

Similarly, the third switch Sw3 may include a transistor Ts3, the fourth switch Sw4 may include a transistor Ts4, and the transistor Ts3 and the transistor Ts4 each include a first terminal, a second terminal, and a gate. The first terminal of the transistor Ts3 is connected to the second power supply terminal SAP, the second terminal of the transistor Ts3 is connected to the third power supply, and the gate of the transistor Ts3 is configured to connect to a third control signal, and switch conduction states of the first terminal and the second terminal based on the third control signal. The first terminal of the transistor Ts4 is connected to the second power supply terminal SAP, the second terminal of the transistor Ts4 is connected to the fourth power supply, and the gate of the transistor Ts4 is configured to connect to a fourth control signal, and switch conduction states of the first terminal and the second terminal based on the fourth control signal. For example, when the access operation of the memory enters the sensing stage, the third control signal is used to enable the transistor Ts3 to be conducted, the fourth control signal is used to enable the transistor Ts4 to be cut off, and the second power supply terminal SAN conducts electricity with the third power supply through the transistor Ts3. When the access operation enters the write-back stage, the third control signal is used to enable the transistor Ts3 to be cut off, the fourth control signal is used to enable the transistor Ts4 to be conducted, and the second power supply terminal SAP conducts electricity with the fourth power supply through the transistor Ts4.

In a possible implementation, the transistor Ts3 and the transistor Ts4 may be transistors of a same type, for example, both are Nmos transistors or both are Pmos transistors. In some other possible implementations, the transistor Ts3 and the transistor Ts4 may be different types of transistors. For example, the transistor Ts3 is an Nmos transistor, and the transistor Ts4 is a Pmos transistor. Because the Nmos transistor is conducted when a voltage of the gate is at a high level, and the Pmos transistor is conducted when a voltage of the gate is at a low level, the third control signal of the transistor Ts3 and the fourth control signal of the transistor Ts4 may be a same control signal.

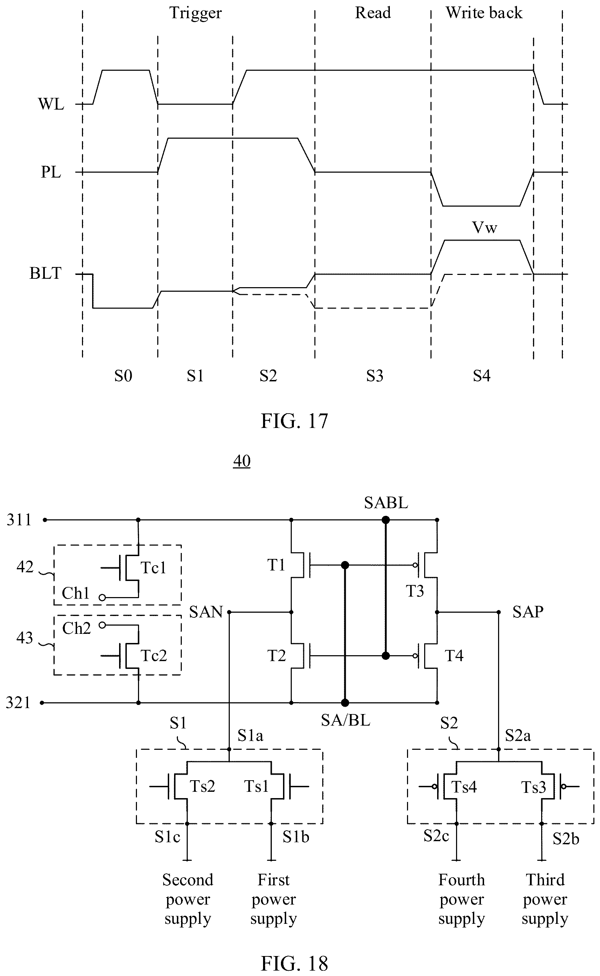

Based on the memory provided in embodiments of this application, FIG. 17 is a timing diagram of a read operation of the memory according to embodiments of this application.

Operation timing of the read operation of the memory provided in embodiments of this application in the activation stage and the read stage is the same as the operation provided in FIG. 8 in the foregoing example, and a difference lies in the write-back stage. In the write-back stage, the excitation voltage Vw needs to be applied to the ferroelectric capacitor to complete write-back. Therefore, the second switch circuit S2 switches the second power supply terminal SAP of the sense amplifier 40 from being connected to the third power supply to being connected to the fourth power supply, to increase the voltage to Vw, so as to increase the voltage of the first bit line 311 to Vw. In addition, to avoid a large difference between voltages of the second power supply terminal SAP and the first power supply terminal SAN that exceeds the withstand voltage range of the thin gate device used by the sense amplifier 40, when the voltage of the second power supply terminal SAP is increased, the voltage of the first power supply terminal SAN also needs to be increased synchronously. The first switch circuit S1 switches the first power supply terminal SAN from being connected to the first power supply to being connected to the second power supply, to reduce the voltage, so as to reduce the voltage of the second bit line 321 to the voltage of the second power supply. The voltage of the second power supply may be an intermediate voltage between the voltage of the first power supply and the voltage of the fourth power supply. For example, the voltage of the fourth power supply is Vw, and the voltage of the second power supply may be Vw/2, or may be another intermediate voltage, to ensure that the voltage difference between the fourth voltage and the voltage of the second power supply does not exceed the withstand voltage range of the thin gate device.

In the operation timing diagram shown in FIG. 17, an example in which the first power supply is 0 V, the second power supply and the third power supply are 1 V, and the fourth power supply is 2 V is used for description.

In the write-back process, the second power supply terminal SAP increases the voltage of the first bit line 311 to 2 V, and the voltage of the plate line is reduced to 0 V, to complete write-back. The voltage of the first power supply terminal SAN is increased to 1 V, the difference between the voltages of the second power supply terminal SAP and the first power supply terminal SAN is 1 V, and falls within the withstand voltage range of the thin gate device used by the sense amplifier 40, and the sense amplifier 40 may not be damaged. The first power supply terminal SAN and the second power supply terminal SAP are connected to different power supplies in different stages through switching, to implement low-voltage and high-sensitivity reading in the sensing and read stages, and ensure that high-voltage write-back in the write-back stage does not damage the sense amplifier 40.

In a possible implementation, refer to FIG. 18, the sense amplifier 40 further includes a first charging circuit 42 and a second charging circuit 43. The first charging circuit 42 is connected to the first bit line 311, the second charging circuit 43 is connected to the second bit line 321, and the first charging circuit 42 and the second charging circuit 43 may charge the first bit line 311 and the second bit line 321 to a specified voltage.

For example, the first charging circuit 42 includes a first charging transistor Tc1. A first terminal of the first charging transistor Tc1 is connected to the first bit line 311, a second terminal of the first charging transistor Tc1 is connected to a first charging terminal Ch1, and a gate of the first charging transistor Tc1 is configured to receive a first charging control signal. The first charging terminal Ch1 may provide different voltages, for example, 0 V or the reference voltage Vref. When the first charging control signal is used to enable the first charging transistor Tc1 to be conducted, the first charging terminal Ch1 may charge the first bit line 311 to the specified voltage, for example, 0 V or the reference voltage Vref.

For example, the second charging circuit 43 includes a second charging transistor Tc2. A first terminal of the second charging transistor Tc2 is connected to the second bit line 321, a second terminal of the second charging transistor Tc2 is connected to a second charging terminal Ch2, and a gate of the second charging transistor Tc2 is configured to receive a second charging control signal. The second charging terminal Ch2 may provide different voltages, for example, 0 V or the reference voltage Vref. When the second charging control signal is used to enable the second charging transistor Tc2 to be conducted, the second charging terminal Ch2 may charge the second bit line 321 to the specified voltage, for example, 0 V or the reference voltage Vref.

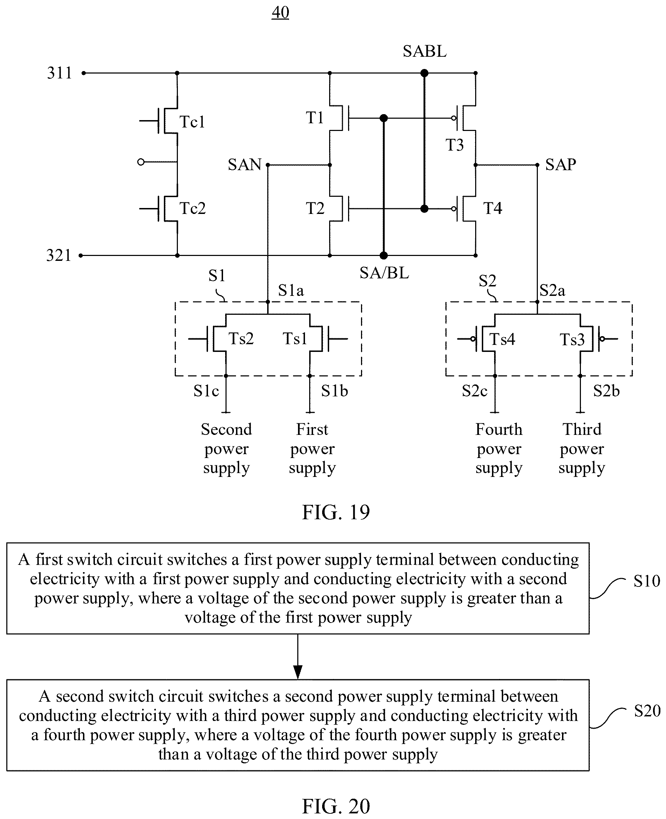

For example, the first charging circuit 42 and the second charging circuit 43 may independently charge bit lines respectively connected to the first charging circuit 42 and the second charging circuit 43. Refer to FIG. 19. If the first charging terminal Ch1 and the second charging terminal Ch2 are a same terminal, and the first charging transistor Tc1 and the second charging transistor Tc2 may be conducted in response to a same charging control signal, the first charging circuit 42 and the second charging circuit 43 may form the equalization circuit in the foregoing example.

In the foregoing example, the solution provided in this application is described by using an example in which the memory is a ferroelectric memory of a 1TnC structure. Because the ferroelectric memory has a feature of a low read voltage, the sense amplifier 40 including the thin gate device with high sensitivity is required to amplify a subtle voltage change on the bit line. However, when the ferroelectric memory writes back or writes data, a high excitation voltage needs to be applied, and exceeds the withstand voltage range of the thin gate device. Therefore, in the memory provided in embodiments of this application, the sense amplifier 40 may be connected to different power signals in the sensing and write-back processes, to meet requirements of low-voltage read and high-voltage write-back of the memory. The memory provided in embodiments of this application may alternatively be any other type of memory that requires low-voltage read and high-voltage write-back, for example, a ferroelectric memory of a 1T1C structure, a ferroelectric memory of a 2T2C structure, or another memory.

Based on the memory provided in the foregoing example, refer to FIG. 20. An embodiment of this application further provides a control method for a memory, including the following steps:
S10: A first switch circuit switches a first power supply terminal between conducting electricity with a first power supply and conducting electricity with a second power supply, where a voltage of the second power supply is greater than a voltage of the first power supply.
S20: A second switch circuit switches a second power supply terminal between conducting electricity with a third power supply and conducting electricity with a fourth power supply, where a voltage of the fourth power supply is greater than a voltage of the third power supply.

For example, in different stages such as sensing, read, and write-back in an access operation of the memory, the first switch circuit may be for the first power supply terminal SAN of a sense amplification circuit to conduct electricity with different power supplies, and the second switch circuit may be for the second power supply terminal SAP of the sense amplification circuit to conduct electricity with different power supplies, to meet power supply voltage requirements of the access operation of the memory in different stages.

For example, in stages such as sensing and read, the first switch circuit is for the first power supply terminal SAN to conduct electricity with the first power supply, and the second switch circuit connects the second power supply terminal SAP to the third power supply. In the write-back stage, to meet a high-voltage write-back condition, the second switch circuit is for the second power supply terminal SAP to conduct electricity with the fourth power supply whose voltage is higher than the voltage of the third power supply, and the first switch circuit is for the first power supply terminal SAN to conduct electricity with the second power supply whose voltage is higher than the voltage of the first power supply. Both a difference between voltages of the third power supply and the first power supply and a difference between voltages of the fourth power supply and the second power supply do not exceed a withstand voltage range of a thin gate device, to prevent a sense amplifier from being damaged.

It should be noted that S1 and S2 may be performed synchronously, or either S1 or S2 may be performed first.

For example, when the first switch circuit switches the power supply connected to the first power supply terminal, and the second switch circuit switches the power supply connected to the second power supply terminal, the method further includes:
The first switch circuit switches the first power supply terminal to conduct electricity with the first power supply, and the second switch circuit switches the second power supply terminal to conduct electricity with the third power supply; or the first switch circuit switches the first power supply terminal to conduct electricity with the second power supply, and the second switch circuit switches the second power supply terminal to conduct electricity with the fourth power supply.

In a possible implementation, the sense amplifier may work in a first working state and a second working state. In the first working state, the first switch circuit is configured for the first power supply terminal to conduct electricity with the first power supply, and the second switch circuit is configured for the second power supply terminal to conduct electricity with the third power supply. In the second working state, the first switch circuit is configured for the first power supply terminal to conduct electricity with the second power supply, and the second switch circuit is configured for the second power supply terminal to conduct electricity with the third power supply. The two different working states may correspond to different working environments of the sense amplifier. In a stage like a sensing stage of an access process of the memory, the first switch circuit and the second switch circuit select to connect to the first power supply and the third power supply. In a stage like a write-back stage, the first switch circuit and the second switch circuit select to connect to the second power supply and the fourth power supply.

Based on the memory provided in the foregoing embodiments, an embodiment of this application further provides a storage device, including a controller and the memory. The controller is electrically connected to the memory, and is configured to control reading and writing of the memory.

Based on the storage device provided in the foregoing embodiments, an embodiment of this application further provides an electronic device, including a circuit board and the storage device electrically connected to the circuit board. For example, the electronic device may be the electronic device shown in FIG. 1 in the foregoing example.

Methods or algorithm steps described in combination with the content disclosed in this application may be implemented by hardware, or may be implemented by a processor by executing a software instruction. The software instructions may include a corresponding software module. The software module may be stored in a random access memory (random access memory, RAM), a flash memory, an erasable programmable read-only memory (erasable programmable ROM, EPROM), an electrically erasable programmable read-only memory (electrically EPROM, EEPROM), a register, a hard disk, a removable hard disk, a compact disc read-only memory (CD-ROM), or any other form of storage medium well known in the art. For example, a storage medium is coupled to the processor, to enable the processor to read information from the storage medium and write the information into the storage medium. Certainly, the storage medium may be a component of the processor. The processor and the storage medium may be located in an ASIC.

A person skilled in the art should be aware that in the foregoing one or more examples, functions described in this application may be implemented by hardware, software, firmware, or any combination thereof. When the functions are implemented by software, the functions may be stored in a computer-readable medium or transmitted as one or more instructions or code in a computer-readable medium. The computer-readable medium includes a computer storage medium and a communication medium. The communication medium includes any medium that facilitates transmission of a computer program from one place to another. The storage medium may be any available medium accessible to a general-purpose or a dedicated computer.

Finally, it should be noted that the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A memory, wherein the memory comprises a memory cell array and a sense amplifier, and the memory cell array comprises a first bit line and a second bit line;
the sense amplifier comprises a sense amplification circuit, a first switch circuit, and a second switch circuit, and the sense amplification circuit comprises a first input terminal, a second input terminal, a first power supply terminal, and a second power supply terminal;
the first input terminal is connected to the first bit line, the second input terminal is connected to the second bit line, the first power supply terminal is connected to the first switch circuit, and the second power supply terminal is connected to the second switch circuit;
the first switch circuit is configured to switch the first power supply terminal between conducting electricity with a first power supply and conducting electricity with a second power supply, wherein a voltage of the second power supply is greater than a voltage of the first power supply; and
the second switch circuit is configured to switch the second power supply terminal between conducting electricity with a third power supply and conducting electricity with a fourth power supply, wherein a voltage of the fourth power supply is greater than a voltage of the third power supply.

2. The memory according to claim 1, wherein in a first working state, the first switch circuit is configured for the first power supply terminal to conduct electricity with the first power supply, and the second switch circuit is configured for the second power supply terminal to conduct electricity with the third power supply; and
in a second working state, the first switch circuit is configured for the first power supply terminal to conduct electricity with the second power supply, and the second switch circuit is configured for the second power supply terminal to conduct electricity with the fourth power supply.

3. The memory according to claim 2, wherein when the sense amplifier is in a write stage, the first switch circuit is configured for the first power supply terminal to conduct electricity with the second power supply, and the second switch circuit is configured for the second power supply terminal to conduct electricity with the fourth power supply; and
when the sense amplifier is in a non-write stage, the first switch circuit is configured for the first power supply terminal to conduct electricity with the first power supply, and the second switch circuit is configured for the second power supply terminal to conduct electricity with the third power supply.

4. The memory according to any one of claims 1 to 3, wherein the first switch circuit comprises a first switch, a second switch, a first common terminal, a first selection terminal, and a second selection terminal, the first common terminal is connected to the first power supply terminal, the first selection terminal is connected to the first power supply, the second selection terminal is connected to the second power supply, the first switch is connected between the first selection terminal and the first common terminal, and the second switch is connected between the second selection terminal and the first common terminal; and
the second switch circuit comprises a third switch, a fourth switch, a second common terminal, a third selection terminal, and a fourth selection terminal, the second common terminal is connected to the second power supply terminal, the third selection terminal is connected to the third power supply, the fourth selection terminal is connected to the fourth power supply, the third switch is connected between the third selection terminal and the second common terminal, and the fourth switch is connected between the fourth selection terminal and the second common terminal.

5. The memory according to any one of claims 1 to 4, wherein the sense amplification circuit further comprises a first transistor, a second transistor, a third transistor, and a fourth transistor;
a first terminal of the first transistor is connected to the first input terminal, a first terminal of the second transistor is connected to the second input terminal, a second terminal of the first transistor and a second terminal of the second transistor are connected to the first power supply terminal, a gate of the first transistor is connected to the second input terminal, and a gate of the second transistor is connected to the first input terminal; and
a first terminal of the third transistor is connected to the first input terminal, a first terminal of the fourth transistor is connected to the second input terminal, a second terminal of the third transistor and a second terminal of the fourth transistor are connected to the second power supply terminal, a gate of the third transistor is connected to the second input terminal, and a gate of the fourth transistor is connected to the first input terminal.

6. The memory according to claim 5, wherein the first transistor and the second transistor are N-type metal-oxide semiconductor field effect transistors, the third transistor and the fourth transistor are P-type metal-oxide semiconductor field effect transistors, and the first transistor, the second transistor, the third transistor, and the fourth transistor are thin gate devices.

7. The memory according to any one of claims 1 to 6, wherein the sense amplifier further comprises a first charging circuit and a second charging circuit;
the first charging circuit is connected to the first bit line; and
the second charging circuit is connected to the second bit line.

8. The memory according to claim 4, wherein a voltage difference between a voltage of the third selection terminal and a voltage of the first selection terminal and a voltage difference between a voltage of the fourth selection terminal and a voltage of the second selection terminal are less than a first voltage, and the voltage of the fourth selection terminal is greater than the first voltage.

9. A control method for a memory, wherein the memory comprises a memory cell array and a sense amplifier, the memory cell array comprises a first bit line and a second bit line, the sense amplifier comprises a sense amplification circuit, a first switch circuit, and a second switch circuit, the sense amplification circuit comprises a first input terminal, a second input terminal, a first power supply terminal, and a second power supply terminal, the first input terminal is connected to the first bit line, the second input terminal is connected to the second bit line, the first power supply terminal is connected to the first switch circuit, the second power supply terminal is connected to the second switch circuit, and the control method comprises:
switching, by the first switch circuit, the first power supply terminal between conducting electricity with a first power supply and conducting electricity with a second power supply, wherein a voltage of the second power supply is greater than a voltage of the first power supply; and
switching, by the second switch circuit, the second power supply terminal between conducting electricity with a third power supply and conducting electricity with a fourth power supply, wherein a voltage of the fourth power supply is greater than a voltage of the third power supply.

10. The method according to claim 9, wherein the method further comprises:
switching, by the first switch circuit, the first power supply terminal to conduct electricity with the first power supply, and switching, by the second switch circuit, the second power supply terminal to conduct electricity with the third power supply; or
switching, by the first switch circuit, the first power supply terminal to conduct electricity with the second power supply, and switching, by the second switch circuit, the second power supply terminal to conduct electricity with the fourth power supply.

11. A storage device, wherein the storage device comprises a controller and the memory according to any one of claims 1 to 8, and the controller is electrically connected to the memory.

12. An electronic device, comprising a circuit board and a storage device electrically connected to the circuit board, wherein the storage device is the storage device according to claim 11.
